# EUROPÄISCHE PATENTSCHRIFT

(11) **EP 1 603 381 B1**
(45) Veröffentlichungstag und Bekanntmachung des Hinweises auf die Patenterteilung: **31.10.2012**
(21) Anmeldenummer: 05013745.4
(22) Anmeldetag: 05.03.2005
(51) Int. Cl.: H05K 9/00

(54) **Federblech in einem Gehäuse als Abschirmung für ein elektronisches hochfrequenztechnisches Gerät**
Contact spring in a casing which is used as shield for an electronic high frequency unit
Plaque ressort dans un boîtier faisant fonction d'écran pour un appareil électronique haute fréquence

(30) Priorität: 12.03.2004 DE 102004012565; 03.03.2005 DE 102005010271
(43) Veröffentlichungstag der Anmeldung: 07.12.2005
(62) Teilanmeldung aus: 05004888.3
(73) Patentinhaber: Hirschmann Car Communication GmbH, 72654 Neckartenzlingen (DE)
(72) Erfinder: Silva, David, 72622 Nürtingen (DE)
(74) Vertreter: Greif, Thomas

(56) Entgegenhaltungen:
- EP-A- 0 755 177
- EP-A- 1 130 953
- US-B1- 6 297 967

## Beschreibung

Die Erfindung betrifft ein elektronisches hochfrequenztechnisches Gerät mit einem Gehäuse aus einem elektrisch leitfähigen Material gemäß den Merkmalen des Oberbegriffes des Patentanspruchs 1.

In diesem Gehäuse des elektronischen Gerätes ist zur Realisierung der Funktion des elektronischen Gerätes zumindest ein elektronisches Modul, insbesondere mehrere Teilmodule, untergebracht. Diese Teilmodule können auf einer gemeinsamen Leiterplatte (Motherboard) angeordnet werden. Diese Anordnung kann beispielsweise über Steckverbinder erfolgen, so dass die Teilmodule, die ihrerseits aus Leiterplatten mit elektronischen Bauteilen bestehen, auf das Motherboard aufgesteckt werden. Aufgrund der Anwendung des elektronischen Gerätes im Hochfrequenzbereich ist es erforderlich, die einzelnen Module untereinander abzuschirmen, um Störungen bei deren Funktion und gegenseitige Beeinflussungen zu vermeiden. Hierzu ist schon vorgeschlagen worden, die einzelnen Module untereinander mittels Abschirmbleche hochfrequenzmäßig voneinander zu trennen bzw. mit einem Abschirmgehäuse zu umgeben. Diese Abschirmbleche bzw. Abschirmgehäuse werden auf dem Motherboard mit Masse kontaktiert, was zu einem gewissen Grad an Abschirmung führt, der allerdings noch nicht befriedigend ist. Außerdem ist es bekannt, dass die Abschirmteile unlösbar mit der Leiterplatte verbunden werden. Dies hat im Defektfall den Nachteil, dass das Abschirmteil nur unter Zerstörung von der Leiterplatte gelöst werden kann oder der Ablöseprozess äußerst aufwändig ist. Dies hat zur Folge, dass sich der Austausch eines defekten elektronischen Modules oder Teilmodules nicht mehr lohnt, da er zu teuer ist.

Aus der EP-A-1 130 953 ist ein elektronisches hochfrequenztechnisches Gerät mit einem Gehäuse aus einem elektrisch leitfähigen Material bekannt, wobei in dem Gehäuse zumindest ein elektronisches Modul sowie ein zugeordnetes Abschirmteil angeordnet ist und weiterhin das Abschirmteil Mittel zur lösbaren Befestigung an einer in dem Gehäuse angeordneten Leiterplatte aufweist. Die Mittel zur lösbaren Befestigung sind als Lasche mit Bohrung an den Abschirmteil ausgebildet, das mit einer Schraubverbindung an der Leiterplatte befestigt ist.

Aus der US-A-6,297,967 ist ein Abschirmteil mit Mittel zur lösbaren Befestigung an einer Leiterplatte bekannt.

Aus der EP-A-0 755 177 ist ein Abschirmteil mit Rastmitteln bekannt, bei dem das Abschirmteil einen Rasthaken aufweist, der durch eine Ausnehmung in einer Leiterplatte durchgeführt wird und die Unterseite der Leiterplatte hintergreift.

Der Erfindung liegt daher die Aufgabe zugrunde, ein elektronisches Gerät mit einem Gehäuse für hochfrequenztechnische Anwendungen bereitzustellen, bei dem die Abschirmung von Modulen oder Teilmodulen innerhalb des Gehäuses verbessert ist, um gegenseitige Beeinflussungen deutlich zu reduzieren, sowie bei dem einfache Montage- und auch Demontageschritte gegeben sind.

Erfindungsgemäß ist vorgesehen, dass die Mittel als Rastmittel ausgebildet sind und die Rastmittel derart federnd ausgebildet ist, dass das Abschirmteil nach dem Festlegen an der Leiterplatte unter Vorspannung steht. Dadurch ist die Möglichkeit' gegeben, das Abschirmteil, schnell und einfach an der Leiterplatte zu befestigen, d.h. auf dieser anzuordnen, aber auch wieder zu demontieren. Die lösbare Befestigung ist in besonders vorteilhafter Weise eine Rastverbindung, wozu das Abschirmteil eine Rastnase mit einem Bogenförmigen vorsprung aufweist, die in eine entsprechende Ausnehmung in der Leiterplatte eingesteckt wird und nach dem vollständigen Einstecken verrastet. Dabei sind die Rastmittel, insbesondere die Rastnase und die korrespondierende Ausnehmung in der Leiterplatte so ausgestattet, dass nach der Verrastung das Abschirmteil zuverlässig und dauerhaltbar an der Leiterplatte festgelegt ist, aber im Falle der Demontage zwecks Austausch des elektronischen Modules einfach gelöst werden kann. Auch der umgekehrte Fall, dass die Leiterplatte einen Vorsprung aufweist und das Abschirmteil mit einer korrespondierenden Ausnehmung versehen ist, ist denkbar, aber auf Grund der aufwändigeren Konstruktion nicht bevorzugt. Denn es bietet sich in besonders vorteilhafter Weise an, dass das Abschirmteil, genau so wie schon die Mittel zur elektrischen Kontaktierung zwischen dem Gehäuse und dem Abschirmteil, aus einem elektrisch leitfähigen Blechmaterial bestehen und mittels eines Stanzverfahrens zwecks Formgebung bearbeitet werden. So können das Abschirmteil (Abschirmblech oder Abschirmgehäuse oder dergleichen) aus einem Blech ausgestanzt, gegebenenfalls umgeformt werden, wobei bei diesem Stanzvorgang auch gleichzeitig die Rastmittel mit angeformt werden. Bei der Formgebung der Rastmittel wird die Rastnase als laschenförmiges Element ausgebildet ist, welches einen bogen förmigen Vorsprung aufweist. Mit diesem Vorsprung wird die Rastnase zuverlässig an der Leiterplatte festgelegt.

Mehrere Ausführungsbeispiele für die erfindungsgemäße einfache und kostengünstige Kontaktierung zwecks Herstellung einer elektrischen Masseverbindung bzw. Montage oder Demontage, auf die die Erfindung jedoch nicht beschränkt ist, sind im Folgenden beschrieben und anhand der Figuren erläutert.

Es zeigen:
- Figuren 1 bis 4:: verschiedene Ausgestaltungen einer Rastanase,
- Figuren 5 und 6:: Ausgestaltungen von Drucklaschen an dem Abschirmteil,
- Figuren 7 und 8:: Ansicht und Detailansicht eines als Abschirmkäfig ausgebildeten Abschirmteiles.

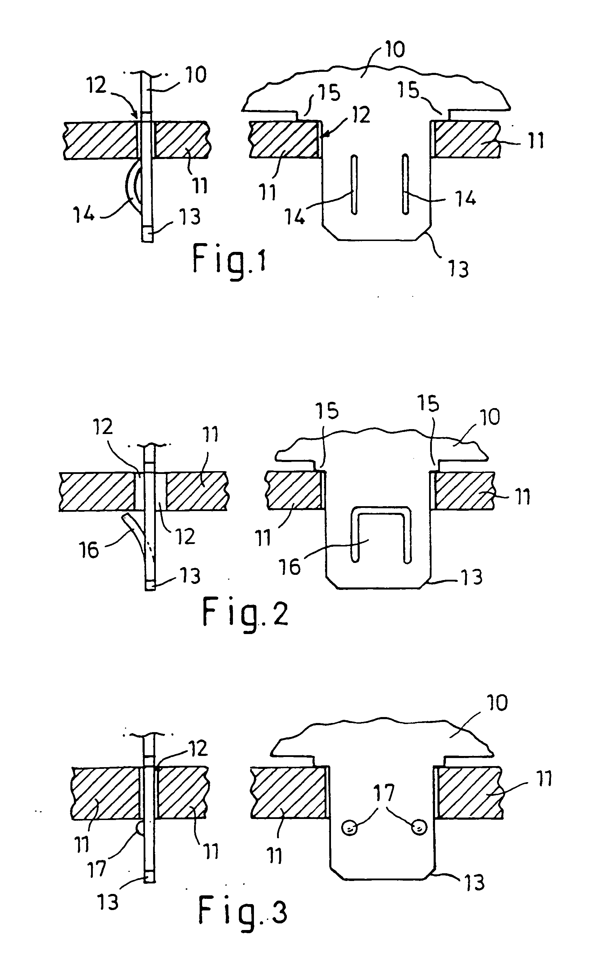

Figur 1 betrifft, soweit im Einzelnen dargestellt, ein Gehäuse eines elektronischen Gerätes für hochfrequenztechnische Anwendungen, so zum Beispiel ein TV-Tuner für den Fernsehempfang, hier insbesondere wieder zur Anwendung bei Fahrzeugen. Dieses Gehäuse ist Bestandteil eines mehrteiligen Gesamtgehäuses, das beispielsweise aus dem Gehäuse als Deckel und einem damit verbindbaren Boden besteht. Der Boden nimmt eine Grundplatine (Motherboard) auf, auf der wiederum mittels Steckverbindungen Teilmodule angeordnet sind. Diese Teilmodule sind beispielsweise senkrecht auf der Grundplatine angeordnet und stehen somit von dieser ab. Bekannt ist es, diese Teilmodule mit einer Abschirmung zu versehen, wobei diese Abschirmung beispielsweise als zwischen den Teilmodulen angeordnete Abschirmbleche ausgebildet ist. Ergänzend oder alternativ dazu können die Teilmodule von einem Abschirmgehäuse umgeben sein. Diese Abschirmbleche oder Abschirmgehäuse sind elektrisch mit einer Masse der Grundplatine kontaktiert.

Die Figuren 1 bis 4 zeigen ausschnittweise ein Abschirmteil 10, das auf einer Leiterplatte 11 des elektronischen Modules innerhalb des Gehäuses anzuordnen ist. Zu diesem Zweck weist die Leiterplatte 11 eine Ausnehmung 12 auf, die zur Aufnahme einer Rastnase 13 des Abschirmteiles 10 ausgebildet ist. Diese Rastnase 13 ist Bestandteil des Abschirmteiles 10 und kann mit diesem mittels eines Stanzvorganges aus einem Blechteil hergestellt werden. Die Abmessungen der Rastnase 13 sind zunächst so gewählt, dass die Rastnase 13 durch die Ausnehmung 12 in der Leiterplatte 11 geführt werden kann. Allerdings ist die Länge der Rastnase 13 größer als die Dicke der Leiterplatte 11, so dass die Rastnase 13 über die Leiterplatte 11 übersteht. Damit ist zunächst das Abschirmteil 10 an der Leiterplatte 11 lagefixiert, allerdings noch nicht gegen eine Herausbewegung aus der Ausnehmung 12 gesichert. Zu diesem Zweck ist gemäß Figur 1 an der Rastnase 13 ein ausgestanzter bogenförmiger Vorsprung 14 vorhanden. Dieser Vorsprung 14 wird beim Einsetzen der Rastnase 13 in die Ausnehmung 12 kurzzeitig zurückgedrückt, springt aber nach dem vollständigen Einsetzen der Rastnase 13 in die Ausnehmung 12 wieder in seine Ursprungsposition (Figur 1, linke Darstellung) zurück, so dass dadurch das Abschirmteil 10 an der Leiterplatte 11 festgelegt ist. Es kann nunmehr auch nicht ohne Weiteres abgenommen werden, dann dazu bedarf es einer solchen Kraft, dass der federnde Vorsprung 14 wieder so weit zurückgedrückt wird, dass die Rastnase 13 aus der Ausnehmung 12 herausgezogen werden kann. Diese Federkraft muss aber eine solche Größe aufweisen, die im normalen Betrieb des elektronischen Gerätes nicht vorkommt. Weiterhin ist in Figur 1 noch gezeigt, dass das Abschirmteil 10 einen Absatz 15 aufweist, der gewährleistet, dass das Abschirmteil 10 mit seiner der Leiterplatte 11 zugewandten unteren umlaufenden Kante nicht vollständig auf der Leiterplatte 11 aufliegt, sondern ein Abstand gegeben ist. Dieser Absatz 15 ist gemäß Figur 1 rechts und links von der Rastnase 13 angeordnet, kann aber auch an beliebigen anderen Stellen an der Unterkante des Abschirmteiles 10 vorhanden sein.

Figur 2 zeigt eine Ausgestaltung wie bei Figur 1, die jedoch nicht zur Erfindung gehört. Hier ist ein ausgestanzter laschenförmiger Vorsprung 16 vorhanden, der ebenfalls beim Einsetzen der Rastnase 13 in die Ausnehmung 12 zurückweicht und nach dem vollständigen Einsetzen wieder zurück springt, so dass dadurch die Rastnase 13 an der Leiterplatte 11 festgesetzt ist. Auch der laschenförmige Vorsprung 16 kann mittels eines Stanzverfahrens einfach und kostengünstig hergestellt werden.

Figur 3 zeigt ebenfalls eine Rastnase 13 die nicht zur Erfindung gehört, die in die Ausnehmung 12 der Leiterplatte 11 eingesetzt wird. Hier weist die Rastnase 13 einen punktförmigen Vorsprung 17 (insbesondere zwei Vorsprünge), die durch Druckverformung herstellbar sind und so an der Rastnase 13 angeordnet werden, dass sie nach vollständigen Einsetzen der Rastnase 13 in die Ausnehmung 12 an der Unterkante der Leiterplatte 11 zur Anlage kommen, um damit, genau so wie die Vorsprünge 14 und 16, das Abschirmteil 10 an der Leiterplatte 11 sicher festlegen.

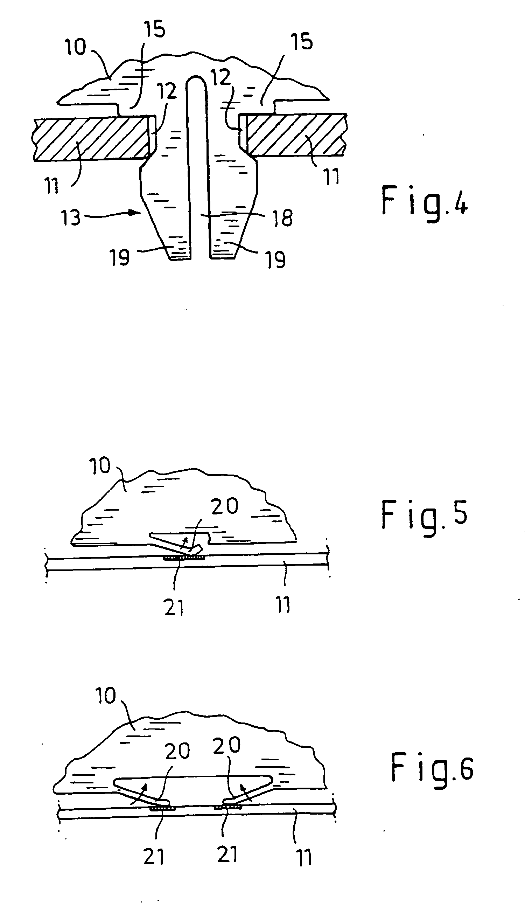

In Figur 4 ist gezeigt, dass die Rastnase 13 federnd ausgebildet ist. Zu diesem Zweck weist die Rastnase 13 zumindest einen Schlitz 18 auf, wodurch sich zwei Laschen 19 bilden, die eine größere Längserstreckung haben, als die Längserstreckung der Ausnehmung 12. Dabei ist die Längserstreckung der beiden Laschen 19 und die Breite des Schlitzes 18 so gewählt, dass beim Einsetzen der Rastnase 13 in die Ausnehmung 12 die beiden Laschen 12 zusammengedrückt und damit die Rastnase 13 durch die Ausnehmung 12 geführt werden kann. Nachdem dies erfolgt ist, spreizen sich die beiden Laschen 19 wieder auseinander, wobei sie in vorteilhafter Weise nicht ihre ursprüngliche Lage einnehmen, sondern unter Vorspannung bleiben. Damit ist auch das Abschirmteil 10 unter einer gewissen Vorspannung an der Leiterplatte 11 festgelegt. Zum Toleranzausgleich weisen die Laschen 19 in ihrem oberen Bereich Abschrägungen auf, mit denen sie an der Unterkante der Leiterplatte 11 im Bereich der Ausnehmung 12 zur Anlage kommen. Zwecks einfacher Einführung der Rastnase 13 in die Ausnehmung 12 sind die Laschen 19 schräg ausgeführt, um eine gewisse Führung beim Einsetzen zu gewährleisten.

Obwohl in den Figuren 1 bis 3 jeweils Absätze 15 gezeigt sind, können diese in dieser Form vorhanden sein, aber auch an anderer Stelle an dem Abschirmteil vorhanden sein oder gänzlich entfallen.

Die Figuren 5 und 6 zeigen Ausgestaltungen dafür, dass das Abschirmteil 10 mit einer Kontaktfläche an der Leiterplatte 11 elektrisch kontaktiert wird. Zu diesem Zweck weist das Abschirmteil 10 zumindest eine Drucklasche 20 auf, die beispielsweise wieder aus dem Abschirmteil ausgestanzt und geformt sein kann. Dabei steht die ausgestanzte und vorgeformte Drucklasche 20 in gewissem Maß über der unteren Kante des Abschirmteiles 10 hervor, so dass sie mit einer Kontaktfläche 21 der Leiterplatte 11 unter Vorspannung zur Anlage kommt und eine elektrische Verbindung zwischen dem Abschirmteil 10 und der Kontaktfläche 21 (Masseverbindung) herstellt. Figur 5 zeigt eine einzige Drucklasche 20, die an ihrem Endbereich leicht abgewinkelt ist. Figur 6 zeigt zwei gegenüberliegende Drucklaschen 20, die jeweils mit einer Kontaktfläche 21 auf der Leiterplatte 11 kontaktiert sind. Das Vorhandensein von mehr als einer Drucklasche 20 hat den Vorteil, dass die Kontaktsicherheit gesteigert ist, für den Fall, dass eine Drucklasche 20 nicht ausreichend die Kontaktfläche 21 kontaktiert oder z.B. auf Grund einer Beschädigung verformt ist und somit keine Kontaktierung gegeben ist.

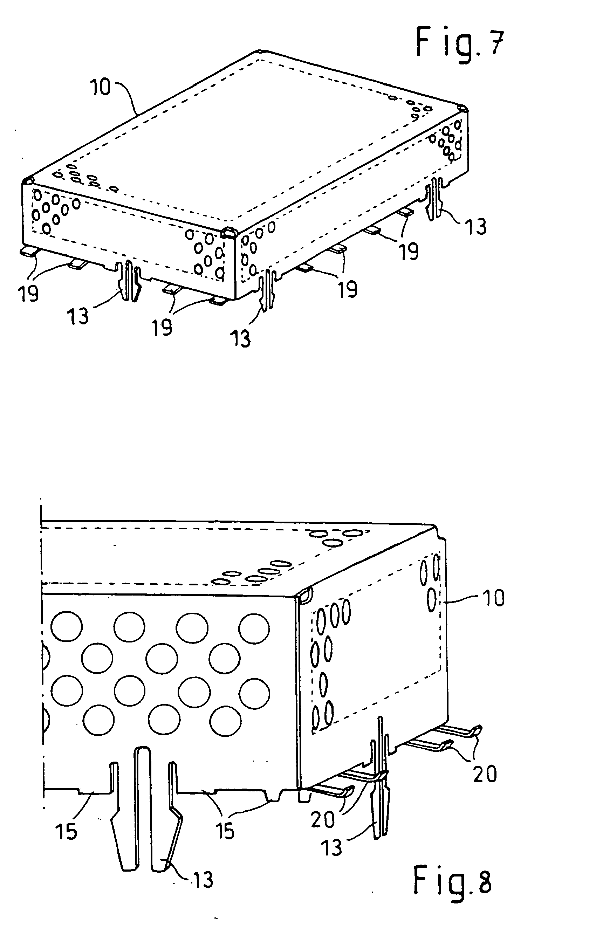

In den Figuren 7 und 8 ist gezeigt, dass das Abschirmteil 10 als Abschirmkäfig ausgebildet ist. Dieser Abschirmkäfig wird auf der Leiterplatte in der vorstehend beschriebenen Weise festgelegt und umgibt damit das elektronische Modul, d.h., die elektronischen Bauteile, die auf der Leiterplatte angeordnet sind, zwecks Abschirmung. Mit diesem Abschirmkäfig wird also wirksam verhindert, dass einerseits von dem elektronischen Modul Störstrahlungen ausgesandt werden, andererseits wird aber auch wirksam verhindert, dass Störstrahlungen von außerhalb, z.B. von anderen elektronischen Modulen, in das mit dem Abschirmkäfig abgeschirmte elektronische Modul einstrahlen können. Zwecks Abschirmung ist es also erforderlich, dass zumindest eine elektronische Modul innerhalb des Gehäuses mit dem Abschirmkäfig zu versehen. Im Regelfall werden innerhalb des Gehäuses mehrere elektronische (Teil-) Module angeordnet sein, die jeweils einen Abschirmkäfig aufweisen oder zwischen denen ein Abschirmblech angeordnet ist. Da zur Sicherstellung der Abschirmung das Abschirmteil auf einem bestimmten elektrischen Potenzial (insbesondere Masse) liegen muss, werden erfindungsgemäß die beiden Alternativen zur Montage und gleichzeitige elektrischen Kontaktierung vorgeschlagenen Lösungen realisiert. Mit Blick auf die Figuren 7 und 8 kann also ein solches Abschirmteil 10 mit den entsprechend ausgebildeten Rastnasen 13 einfach und schnell auf der Leiterplatte 11 (hier nicht dargestellt) montiert und demontiert werden. Die elektrische Kontaktierung des Abschirmteiles 10 erfolgt dann über die Drucklaschen 20, die mit Kontaktflächen 21 auf der Leiterplatte 11 korrespondieren und/oder über das FederbJech 6, welches an dem Abschirmteil 10 oder an der Innenseite des Gehäuses vorhanden ist, und das Abschirmteil 10 elektrisch mit dem Gehäuse kontaktiert. Diese Kontaktierung erfolgt in besonders vorteilhafter Weise, wenn das elektronische Modul mit dem Abschirmteil 10 in das Gehäuse eingesetzt wird bzw. das elektronische Modul schon auf einer Grundplatte des Gehäuses montiert ist und anschließend das Gehäuse zum Verschließen montiert wird.

Die erfindungsgemäßen Mittel zur elektrischen Kontaktierung zwischen dem Abschirmteil 10 und dem Gehäuse haben in allen Varianten den Vorteil, dass sie einfach und kostengünstig, insbesondere in einem Stanzverfahren oder einem Stanzbiegeverfahren, herstellbar sind und gleichzeitig eine Demontage bestehen bleibt, ohne dass es zu einer aufwändigen Demontage oder einer Zerstörung der beteiligten Teile kommt.

### Bezugszeichenliste

- 10.: Abschirmteil
- 11.: Leiterplatte
- 12.: Ausnehmung
- 13.: Rastnase
- 14.: ausgestanzter bogenförmiger Vorsprung
- 15.: Absatz
- 16.: ausgestanzter laschenförmiger Vorsprung
- 17.: punktförmiger Vorsprung
- 18.: Schlitz
- 19.: Lasche
- 20.: Drucklasche
- 21.: Kontaktfläche

## Patentansprüche

1. Elektronisches hochfrequenztechnisches Gerät mit einem Gehäuse aus einem elektrisch leitfähigen Material, wobei in dem Gehäuse zumindest ein elektronisches Modul sowie ein zugeordnetes Abschirmteil (10) angeordnet ist, wobei das Abschirmteil (10) Mittel zur lösbaren Befestigung an einer in dem Gehäuse angeordneten Leiterplatte (11) aufweist, dadurch gekennzeichet, dass die Mittel als Rastmittel ausgebildet sind und die Rastmittel derart federnd ausgebildet sind, dass das Abschirmteil (10) nach dem Festlegen an der Leiterplatte (11) unter Vorspannung steht wobei die Rastnase (13) einen bogenförmigen Vorsprung (14) aufweist, und das Gerät ein TV-Tuner für den Fernsehempfeng zur Anwendung bei Fahrzeugen ist.

2. Gerät nach Anspruch 1, **dadurch gekennzeichnet, dass** die Rastmittel als eine Rastnase (13) ausgebildet sind.

3. Gerät nach einem der vorhergehenden Ansprüche, **dadurch gekennzeichnet, dass** das Abschirmteil (10) als Abschirmblech oder Abschirmkäfig ausgebildet ist.

4. Gerät nach einem der vorhergehenden Ansprüche, **dadurch gekennzeichnet, dass** das Abschirmteil (10) mittels eines Stanzbiegeverfahrens aus einem Blech herstellbar ist.

## Claims

1. Electronic high-frequency device having a housing made from an electrically conductive material, wherein at least one electronic module and an associated screening part (10) are arranged in the housing, wherein the screening part (10) comprises means for providing a releasable fastening to a motherboard (11) arranged in the housing, **characterized in that** the means are embodied as latching means and the latching means are embodied in a resilient manner such that the screening part (10) is pre-stressed once fixed on the motherboard (11), wherein the latching protrusion (13) comprises an arcuate protrusion (14) and the device is a TV-tuner for television reception for use in vehicles.

2. Device according to Claim 1, **characterized in that** the latching means are embodied as a latching protrusion (13).

3. Device according to any one of the preceding claims, **characterized in that** the screening part (10) is embodied as a screening sheet metal plate or screening cage.

4. Device according to any one of the preceding claims, **characterized in that** the screening part (10) can be produced from a sheet metal plate by means of a stamping and bending method.

## Revendications

1. Appareil électronique en technique des hautes fréquences comprenant un boîtier en un matériau électriquement conducteur, au moins un module électronique ainsi qu'une pièce de blindage (10) associée étant disposés dans le boîtier, la pièce de blindage (10) présentant des moyens pour la fixation amovible à un circuit imprimé (11) disposé dans le boîtier, **caractérisé en ce que** les moyens sont réalisés sous la forme de moyens à enclenchement et les moyens à enclenchement sont réalisés flexibles de sorte que la pièce de blindage (10) se trouve sous précontrainte après sa fixation au circuit imprimé (11), le tenon d'enclenchement (13) présentant une partie en saillie (14) de forme cintrée et l'appareil est un tuner TV pour la réception de télévision destiné à être utilisé sur les véhicules.

2. Appareil selon la revendication 1, **caractérisé en ce que** les moyens à enclenchement sont réalisés sous la forme d'un tenon d'enclenchement (13).

3. Appareil selon l'une des revendications précédentes, **caractérisé en ce que** la pièce de blindage (10) est réalisée sous la forme d'une tôle de blindage ou d'une cage de blindage.

4. Appareil selon l'une des revendications précédentes, **caractérisé en ce que** la pièce de blindage (10) peut être fabriquée à partir d'une tôle au moyen d'un procédé de façonnage à la presse.
